# EUROPÄISCHE PATENTSCHRIFT

(11) **EP 0 352 630 B1**
(45) Veröffentlichungstag und Bekanntmachung des Hinweises auf die Patenterteilung: **17.08.1994**
(21) Anmeldenummer: 89113306.8
(22) Anmeldetag: 20.07.1989
(51) Int. Cl.: G03F 7/11, G03F 7/027

(54) **Photopolymerisierbares Aufzeichnungsmaterial**
Photopolymerisable registration material
Matériau d'enregistrement photopolymérisable

(30) Priorität: 29.07.1988 DE 3825836
(43) Veröffentlichungstag der Anmeldung: 31.01.1990
(73) Patentinhaber: HOECHST AKTIENGESELLSCHAFT, 65926 Frankfurt am Main (DE)
(72) Erfinder: Zertani, Rudolf, Dr., D-6500 Mainz-Bretzenheim (DE); Mohr, Dieter, Dr., D-6501 Budenheim (DE)

(56) Entgegenhaltungen:
- DE-A- 3 432 846
- FR-A- 2 099 334
- US-A- 3 458 311
- PATENT ABSTRACTS OF JAPAN vol. 10, no. 41 (P-429)(2098) 18 Februar 1986,& JP-A-60 186835

## Beschreibung

Die Erfindung betrifft ein photopolymerisierbares Aufzeichnungsmaterial mit einem Schichtträger, einer photopolymerisierbaren Schicht und einer Deckschicht, die für Luftsauerstoff wenig durchlässig ist. Das Material ist besonders für die Herstellung von Druckplatten, insbesondere Flachdruckplatten, geeignet.

Druckplatten der genannten Gattung sind z. B. aus der US-A 3 458 311 bekannt. Dort werden Deckschichten beschrieben, die aus wasserlöslichen Polymeren, z. B. Polyvinylalkohol, Polyvinylpyrrolidon, Gelatine oder Gummi arabicum, bestehen. Von diesen Substanzen wird Polyvinylalkohol bevorzugt, da seine Dämmwirkung gegenüber Sauerstoff sehr hoch ist. Es wurde aber gefunden, daß photopolymerisierbare Druckplatten mit einer Deckschicht aus Polyvinylalkohol bei dar Lagerung innerhalb von Wochen und Monaten einen Teil ihrer Lichtempfindlichkeit verlieren. Auch wurde beobachtet daß die Schutzwirkung mit steigender Temperatur und mit steigender Luftfeuchtigkeit stark abnimmt. In der Tat konnte bestätigt werden, daß die Sauerstoffdurchlässigkeit von Polyvinylalkohol mit der Temperatur und der Luftfeuchtigkeit stark zunimmt. Dieser Nachteil fällt besonders erschwerend ins Gewicht, wenn es sich um hochlichtempfindliche photopolymerisierbare Gemische mit photooxydierbaren Substanzen und speziellen synergistischen Initiatorkombinationen handelt. Derartige Gemische sind in den älteren EP-A 287 818, 287 817, 284 938 und 321 826 beschrieben.

Es ist auch bekannt, der photopolymerisierbaren Schicht selbst Substanzen, z. B. Zinnsalze oder Antioxydantien, zuzusetzen, um den in die Schicht eindiffundierenden Sauerstoff abzufangen. Derartige Zusätze sind z. B. in einem Artikel von E. T. Denisov et al. in Chem. Rev. 1987, S. 1313-1357, beschrieben. Da derartige Verbindungen meist unerwünschte Nebenwirkungen zeigen und insbesondere die Lichtempfindlichkeit herabsetzen, hat sich ihre Anwendung in der Praxis nicht durchgesetzt.

Aus der JP-A 85/186 835 ist ein photopolymerisierbares Material für die Herstellung von Reliefdruckplatten bekannt, das auf der photopolymerisierbaren Schicht eine Schicht aus einer Mischung von Polyvinylalkohol und Polyethylenimin trägt, die die Klebrigkeit der Oberfläche verhindern soll.

In der DE-A 34 32 846 wird ein lichtempfindliches Material beschrieben, das auf der lichtempfindlichen Schicht eine das Zusammenkleben verhindernde Schicht aufweist, die u. a. Polyvinylalkohol oder Polyethylenimin enthalten kann.

Aufgabe der Erfindung war es, photopolymerisierbare Aufzeichungsmaterialien mit sauerstoffhemmenden Deckschichten vorzuschlagen, deren Lichtempfindlichkeit bei der Lagerung nicht oder in geringerem Maße abnimmt als bei bekannten Materialien dieser Art und die insbesondere weniger empfindlich gegen Lagerung bei höheren Temperaturen und Luftfeuchtigkeiten sind.

Die Erfindung geht aus von einem photopolymerisierbaren Aufzeichnungsmaterial mit einem Schichtträger, einer photopolymerisierbaren Schicht, die als wesentliche Bestandteile ein polymeres Bindemittel, eine radikalisch polymerisierbare Verbindung mit mindestens einer photooxydierbaren Gruppe und mindestens einer endständigen ethylenisch ungesättigten Gruppe sowie einen durch aktinisches Licht aktivierbaren Polymerisationsinitiator enthält, und einer Deckschicht, die ein für Luftsauerstoff wenig durchlässiges, wasserlösliches Polymeres enthält.

Das erfindungsgemäße Material ist dadurch gekennzeichnet, daß die Deckschicht ferner ein Luftsauerstof bindendes, in Wasser bei 20 °C praktisch vollständig lösliches Polymeres enthält.

Als Luftsauerstoff bindende wasserlösliche Polymere sind insbesondere Verbindungen mit aliphatischen Aminogruppen geeignet, die primär, sekundär oder tertiär sein können. Die Polymeren sollten vorzugsweise außer den Aminogruppen keine weiteren funktionellen Gruppen enthalten. Ihre Molekulargewichte liegen im allgemeinen im Bereich von 300 bis 1 000 000, bevorzugt 1 000 bis 200 000, insbesondere 10 000 bis 200 000.

Als Aminogruppen enthaltende Polymere werden vorzugsweise lineare oder verzweigte Polyalkylenimine eingesetzt, deren Alkylengruppen 2 bis 8, insbesondere 2 bis 4 Kohlenstoffatome enthalten. Besonders vorteilhaft sind Polyalkylenimine, insbesondere Polyethylen- und Polypropylenimine, mit Molekulargewichten von 18 000 bis 80 000.

Die Polyalkylenimine können durch säurekatalysierte Polymerisation aus Alkyleniminen, z. B. Ethylen- oder Propylenimin, hergestellt werden, wie es in der US-A 2 223 930 beschrieben ist. Produkte mit höheren Molekulargewichten können durch Umsetzen mit bifunktionellen Alkylierungsmitteln, z. B. 1,2-Dichlorethan, und solche mit niedrigen Molekulargewichten durch Zusetzen von 1,2-Ethylendiamin, wie es in der US-A 3 519 687 beschrieben ist, erhalten werden. Derartige Polyalkylenimine sind Handelsprodukte. Ein bevorzugtes Beispiel enthält etwa 30 % primäre, 40 % sekundäre und 30 % tertiäre Aminogruppen.

Das für Luftsauerstoff wenig durchlässige Polymere kann eines der in der US-A 3 458 311 angegebenen Polymeren sein. Beispiele sind insbesondere Polyvinylalkohol und teilverseifte Polyvinylacetate, die auch Vinylether- und Vinylacetaleinheiten enthalten können, solange das Polymere bei 20 °C wasserlöslich bleibt. Ferner können Gelatine, Gummi arabicum, Mischpolymerisate von Alkylvinylethern und Maleinsäureanhydrid, Polyvinylpyrrolidone und wasserlösliche hochmolekulare Polymerisate von Ethylenoxid (M = 100 000 bis 3 000 000) eingesetzt werden. Bevorzugt werden solche Polymere, deren Sauerstoffdurchlässigkeit in einer Schicht bei 20 °C kleiner als 30, insbesondere kleiner als 25 cm³/m²/d/bar ist.

Die Deckschicht soll für aktinisches Licht durchlässig sein und hat im allgemeinen eine Dicke von 0,5 bis 10, vorzugsweise 1 bis 4 µm. Sie enthält im allgemeinen 3 bis 60, vorzugsweise 5 bis 40 Gew.-% Sauerstoff bindendes Polymeres, insbesondere Polyalkylenimin, bezogen auf den Gesamtfeststoffgehalt. Die Deckschicht wird in bekannter Weise aus wäßriger Lösung oder aus einem Gemisch von Wasser und organischem Lösemittel auf die photopolymerisierbare Schicht aufgebracht. Der Beschichtungslösung können zur besseren Benetzung bis zu 10 Gew.-%, vorzugsweise bis zu 5 Gew.-% eines oberflächenaktiven Mittels, bezogen auf ihren Feststoffgehalt, zugesetzt werden. Zu den brauchbaren oberflächenaktiven Substanzen gehören die anionischen, kationischen und nichtionischen oberflächenaktiven Mittel, z. B. Natriumalkylsulfate und -sulfonate mit 12 bis 18 Kohlenstoffatomen wie Natriumdodecylsulfat, N-Cetyl- und C-Cetylbetaine, Alkylaminocarboxylate und -dicarboxylate sowie Polyethylenglykole mit einem durchschnittlichen Molekulargewicht bis 400.

Die Deckschichten des erfindungsgemäßen Materials haben eine geringere Sauerstoffdurchlässigkeit als die bekannten Deckschichten, die nur ein sauerstoffdämmendes Polymeres, z. B. Polyvinylalkohol, und gegebenenfalls ein Netzmittel enthalten. Die Schutzwirkung ist insbesondere bei erhöhten Temperaturen und bei erhöhter Luftfeuchtigkeit verbessert und hält bei der Lagerung über längere Zeiträume hin an als die der bekannten Schutzschichten. Da die hohe spezifische Schutzwirkung die Anwendung relativ dünner Deckschichten (0,5 bis 2,5 /um) erlaubt, wird eine gute optische Auflösung erreicht. Diese Eigenschaft ist besonders bei Offsetdruckplatten auf Basis photopolymerisierbarer Materialien verbesserungsbedürftig.

Die photopolymerisierbaren Schichten der erfindungsgemäßen Aufzeichnungsmaterialien enthalten als wesentliche Bestandteile ein polymeres Bindemittel, eine radikalisch polymerisierbare Verbindung mit mindestens einer photooxydierbaren Gruppe und mindestens einer, bevorzugt mindestens zwei endständigen ethylenisch ungesättigten Gruppen sowie einen durch aktinisches Licht aktivierbaren Polymerisationsinitiator bzw. eine Initiatorkombination.

Für die Zwecke der Erfindung geeignete polymerisierbare Verbindungen sind Acryl- und Methacrylsäure-ester von zwei- oder mehrwertigen Alkoholen, die mindestens eine photooxydierbare und gegebenenfalls mindestens eine Urethangruppe im Molekül enthalten.

Als photooxydierbare Gruppen kommen insbesondere Aminogruppen, Harnstoffgruppen, Thiogruppen, die auch Bestandteile heterocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind Acryl- und Alkacrylsäureester der Formel I 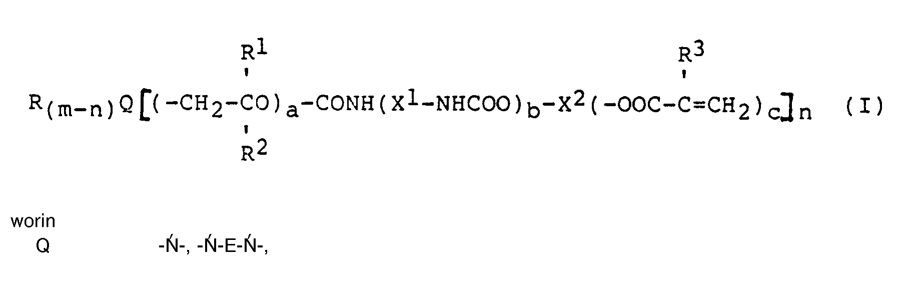
worin
- Q: -Ń-, -Ń-E-Ń-, 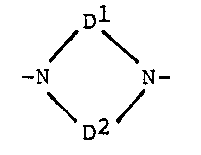 oder -S-
- R: eine Alkyl-, Hydroxyalkyl- oder Arylgruppe,
- R¹ und R²: jeweils ein Wasserstoffatom, eine Alkylgruppe oder Alkoxyalkylgruppe,
- R³: ein Wasserstoffatom, eine Methyl- oder Ethylgruppe,
- X¹: eine gesättigte Kohlenwasserstoffgruppe mit 2 bis 12 Kohlenstoffatomen,
- X²: eine (c+l)-wertige gesättigte Kohlenwasserstoffgruppe, in der bis zu 5 Methylengruppen durch Sauerstoffatome ersetzt sein können,
- D¹ und D²: jeweils eine gesättigte Kohlenwasserstoffgruppe mit 1 bis 5 Kohlenstoffatomen,
- E: eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen oder eine heterocyclische aromatische Gruppe mit 5 oder 6 Ringgliedern,
- a: 0 oder eine ganze Zahl von 1 bis 4,
- b: 0 oder 1,
- c: eine ganze Zahl von 1 bis 3,
- m: je nach Wertigkeit von Q 2, 3 oder 4 und
- n: eine ganze Zahl von 1 bis m
bedeutet, wobei alle Symbole gleicher Definition untereinander gleich oder verschieden sein können.

Die Verbindungen dieser Formel, ihre Herstellung und Verwendung sind ausführlich in der älteren EP-A 287 818 beschrieben.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig und gegebenenfalls durch Alkyl- oder Alkoxygruppen mit bis zu 5 Kohlenstoffatomen oder Halogenatomen substituiert sein.

Wenn R¹ und R² Alkyl- oder Alkoxyalkylgruppen sind, können diese 1 bis 5 Kohlenstoffatome enthalten.

R³ ist bevorzugt ein Wasserstoffatom oder eine Methylgruppe, insbesondere eine Methylgruppe.

X¹ ist bevorzugt ein geradkettiger oder verzweigter aliphatischer oder cycloaliphatischer Rest mit vorzugsweise 4 bis 10 Kohlenstoffatomen.

X² hat vorzugsweise 2 bis 15 Kohlenstoffatome, von denen bis zu 5 durch Sauerstoffatome ersetzt sein können. Wenn es sich um reine Kohlenstoffketten handelt, werden im allgemeinen solche mit 2 bis 12, vorzugsweise 2 bis 6 Kohlenstoffatomen eingesetzt. X² kann auch eine cycloaliphatische Gruppe mit 5 bis 10 Kohlenstoffatomen, insbesondere eine Cyclohexylengruppe sein.

D¹ und D² können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese vorzugsweise 2 bis 6 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Der Wert von c ist vorzugsweise 1.

Die polymerisierbaren Verbindungen der Formel I, die zwei Urethangruppen in jedem Rest (b = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen, N,N-Bis-hydroxyalkyl-piperazinen oder N,N,N′,N′-Tetra-hydroxyalkyl-alkylendiaminen, umgesetzt wird, wobei einzelne Hydroxyalkylgruppen durch Alkyl- oder Arylgruppen R ersetzt sein können. Wenn a = 0 ist, entsteht eine Harnstoffgruppierung.

Beispiele für die als Ausgangsstoffe verwendeten Hydroxyalkylamine sind Triethanolamin, N-Alkyl-N,N-di(hydroxyalkyl)amine, Diethanolamin, Tris-(2-hydroxypropyl)amin oder Tris-(2-hydroxybutyl)amin.

Beispiele für die als Ausgangsstoffe verwendeten Diisocyanate sind Hexamethylendiisocyanat, 2,2,4-Trimethylhexamethylendiisocyanat, 1,4-Cyclohexylendiisocyanat und 1,1,3-Trimethyl-3-isocyanatomethyl-5-isocyanatocyclohexan.

Als Hydroxygruppen enthaltende Ester werden insbesondere Hydroxyethylmethacrylat und Hydroxypropylmethacrylat (n oder iso) sowie die entsprechenden Acrylate verwendet.

Die polymerisierbaren Verbindungen der Formel I mit b = 0 werden dargestellt, indem die oben beschriebenen Hydroxyalkylaminoverbindungen mit Isocyanatgruppen enthaltenden Acryl- oder Alkylacrylsäureestern umgesetzt werden. Als Isocyanatgruppen enthaltender Ester wird insbesondere Isocyanatoethyl(meth)acrylat eingesetzt.

Weitere geeignete Verbindungen mit photooxydierbaren Gruppen sind Verbindungen der Formel II 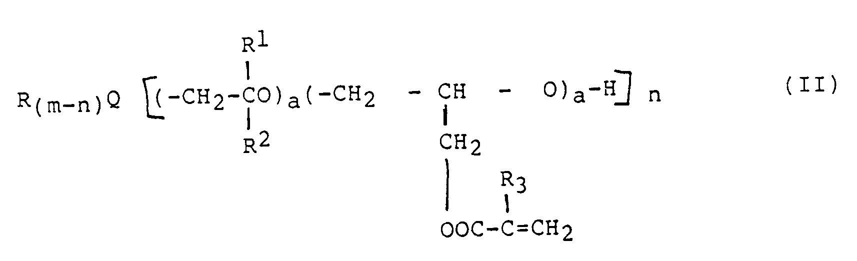
worin Q, R, R¹, R², R³, a, m und n die oben angegebene Bedeutung haben und Q zusätzlich eine Gruppe 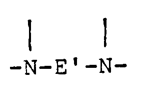
sein kann, worin E' eine Gruppe der Formel III 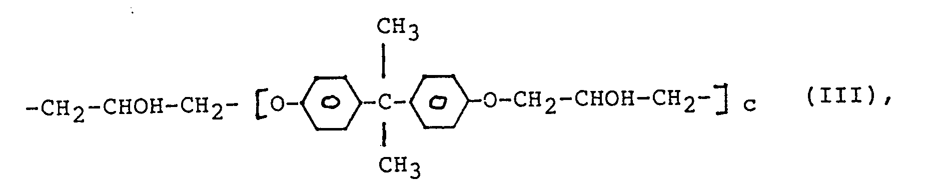
ist.

Die Herstellung der Verbindungen der Formel II erfolgt analog derjenigen der Formel I, wobei anstelle von Hydroxyalkyl(alk)acrylaten die entsprechenden (Alk)acrylsäureglycidylester eingesetzt werden.

Die Verbindungen dieser Formel, ihre Herstellung und Verwendung sind ausführlich in der älteren EP-A 316 706 beschrieben.

Weitere geeignete Verbindungen mit photooxydierbaren Gruppen sind Acryl- und Alkacrylsäureester der Formel IV 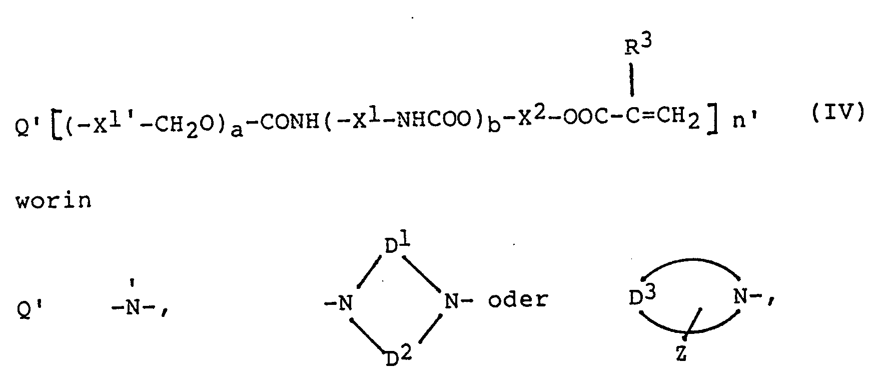
- X^{1'}: CᵢH₂ᵢ oder 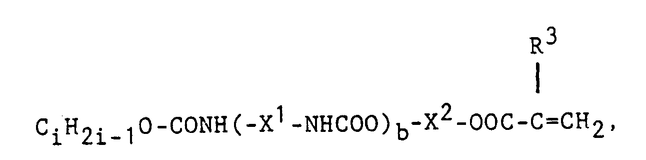
- D³: eine gesättigte Kohlenwasserstoffgruppe mit 4 bis 8 Kohlenstoffatomen, die mit dem Stickstoffatom einen 5- oder 6-gliedrigen Ring bildet,
- Z: ein Wasserstoffatom oder einen Rest der Formel 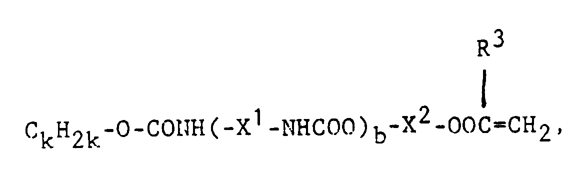
- i und k: ganze Zahlen von 1 bis 12,
- n′: je nach Wertigkeit von Q′ 1, 2 oder 3
bedeutet, und R³, X¹, X², D¹, D², a und b die bei Formel I angegebene Bedeutung haben, wobei alle Symbole gleicher Definition untereinander gleich oder verschieden sein können und wobei in mindestens einem Substituenten an der Gruppe Q a = 0 ist.

Von den Verbindungen der Formel IV werden solche bevorzugt, die außer einer Harnstoffgruppe mindestens eine Urethangruppe enthalten. Als Harnstoffgruppen sollen Gruppen der Formel

〉N - CO - N〈

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht.

Das Symbol a ist in Formel IV vorzugsweise 0 oder 1; i ist vorzugsweise eine Zahl von 2 bis 10.

Die polymerisierbaren Verbindungen der Formel IV werden analog zu den Verbindungen der Formel I hergestellt.

Die Verbindungen der Formel IV und ihre Herstellung sind ausführlich in der älteren EP-A 355 387 beschrieben.

Der Mengenanteil der photopolymerisierbaren Schicht an polymerisierbaren Verbindungen beträgt im allgemeinen etwa 10 bis 80, bevorzugt 20 bis 60 Gew.-%, bezogen auf die nichtflüchtigen Bestandteile.

Beispiele für verwendbare Bindemittel sind chloriertes Polyethylen, chloriertes Polypropylen, Poly(meth)acrylsäurealkylester, bei denen die Alkylgruppe z. B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/ Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z. B. Nylon-6), Polyurethane, Methylcellulose, Ethylcellulose, Acetylcellulose, Polyvinylformal und Polyvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin sind geeignet Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:
Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z. B. Novolake.

Die Menge des Bindemittels in der lichtempfindlichen Schicht beträgt im allgemeinen 20 bis 90, vorzugsweise 40 bis 80 Gew.-%.

Als Photoinitiatoren können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinazoline ableiten; ferner Trichlormethyl-s-triazine, 2-Halogenmethyl-5-vinyl-1,3,4-oxadiazolderivate, mit Trichlormethylgruppen substituierte Halogenoxazole oder Trihalogenmethylgruppen enthaltende Carbonylmethylenheterocyclen, wie sie in der DE-A 33 33 450 angegeben sind.

Bevorzugt werden als Photoinitiatoren photoreduzierbare Farbstoffe, insbesondere in Kombination mit durch Belichtung spaltbaren Trihalogenmethylverbindungen und gegebenenfalls mit als Photoinitiatoren wirksamen Acridin-, Phenazin- oder Chinoxalinverbindungen, wie sie in den älteren EP-A 287 817 und 284 938 beschrieben sind.

Geeignete photoreduzierbare Farbstoffe sind insbesondere Xanthen-, Benzoxanthen-, Benzothioxanthen-, Thiazin-, Pyronin, Porphyrin- oder Acridinfarbstoffe. Die Menge des Farbstoffs liegt im allgemeinen zwischen 0,01 und 10, vorzugsweise zwischen 0,05 und 4 Gew.-%, bezogen auf die nichtflüchtigen Bestandteile der Schicht.

Zur Steigerung der Lichtempfindlichkeit können den Schichten Verbindungen mit photolytisch spaltbaren Trihalogenmethylgruppen, die als radikalbildende Photoinitiatoren für photopolymerisierbare Gemische an sich bekannt sind, zugesetzt werden. Als derartige Coinitiatoren haben sich besonders Verbindungen mit Chlor und Brom, insbesondere Chlor, als Halogene bewährt. Die Trihalogenmethylgruppen können direkt oder über eine durch-konjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyl-tribrommethylsulfon, sind geeignet.

Diese Komponenten werden im allgemeinen in einer Menge von 0,01 bis 10, vorzugsweise von 0,05 bis 6 Gew.-%, bezogen auf die nichtflüchtigen Bestandteile der Schicht, eingesetzt.

Die erfindungsgemäßen Marerialien enthalten vorzugsweise als weiteren Initiatorbestandteil eine Acridin-, Phenazin- oder Chinoxalinverbindung. Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Die Menge dieser Komponente liegt ebenfalls im Bereich von 0,01 bis 10 Gew.-%, vorzugsweise zwischen 0,05 und 5 Gew.-%.

Wenn eine weitere Empfindlichkeitssteigerung im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Die Menge dieser Verbindung liegt ebenfalls im Bereich von 0,01 bis 10, vorzugsweise von 0,05 bis 4 Gew.-%.

Die Gesamtmenge an Polymerisationsinitiatoren liegt im allgemeinen bei 0,05 bis 20, vorzugsweise bei 0,1 bis 10 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung. Die Lichtempfindlichkeit reicht von etwa 200 nm bis 800 nm und umspannt damit einen sehr breiten Bereich.

Als Anwendungsmöglichkeiten für das erfindungsgemäße Material seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Als Schichtträger für das erfindungsgemäße Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen.

Durch die breite spektrale Empfindlichkeit des erfindungsgemäßen Aufzeichnungsmaterials können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten. Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

### Beispiel 1 (Vergleichsbeispiel)

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit einer Lösung folgender Zusammensetzung überzogen:
2,84 Gt einer 22,3 %igen Lösung eines Terpolymerisats aus Styrol, n-Hexylmethacrylat und Methacrylsäure (10:60:30) mit der Säurezahl 190 in Methylethylketon,
1,49 Gt des Umsetzungsprodukts von Triethanolamin mit 3 mol Isocyanatoethylmethacrylat,
0,04 Gt Eosin alkohollöslich (C.I. 45 386),
0,03 Gt 2,4-Bis-trichlormethyl-6-(4-styryl-phenyl)-s-triazin und
0,049 Gt 9-Phenylacridin in
22 Gt Propylenglykolmonomethylether.

Das Auftragen erfolgte durch Aufschleudern in der Weise, daß ein Trockengewicht von 2,8 bis 3 g/m² erhalten wurde. Anschließend wurde die Platte zwei Minuten bei 100°C im Umlufttrockenschrank getrocknet. Die Platte wurde dann mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4 bis 5 g/m² erhalten. Die erhaltene Druckplatte wurde mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Druckplatte im sichtbaren Licht zu testen, wurden auf den Belichtungskeil jeweils 3 mm starke Kantenfilter der Firma Schott mit den in der Tabelle angegebenen Kantendurchlässigkeiten montiert. Nach der Belichtung wurde die Platte eine Minute auf 100° C erwärmt. Anschließend wurde sie mit einem Entwickler folgender Zusammensetzung entwickelt:
120 Gt Natriummetasilikat · 9 H₂O,
2,13 Gt Strontiumchlorid,
1,2 Gt nichtionogenes Netzmittel (Kokosfettalkohol-Polyoxyethylenether mit ca. 8 Oxyethyleneinheiten) und
0,12 Gt Antischaummittel in
4000 Gt vollensalztem Wasser.

Die Platte wurde mit fetter Druckfarbe eingefärbt. Es wurden die folgenden vollvernetzten Keilstufen erhalten. Das Auflösungsvermögen der Druckplatte wurde mit einer Testvorlage, dem PMS-Keil (FOGRA), bestimmt und an der Kopie abgelesen.

| Belichtung (Sekunden) | Graufilter | Kantenfilter | Keilstufen | Auflösung (µm) |
|---|---|---|---|---|
| 10 | ja | - | 11 | 25 |
| 10 | nein | 455 | 9 | 25 |

Die Druckplatte wurde auf ihre Lagerstabilität hin geprüft. Hierzu wurden Proben davon bei 80 °C mehrere Stunden in einem Umlufttrockenschrank gelagert. Nach den in Tabelle I angegebenen Zeiten wurden sie wie oben belichtet und entwickelt. Es wurden die folgende Anzahl vollvernetzer Keilstufen unter dem Kantenfilter 455 nm erhalten:

**Tabelle I**

| Lagertest bei 80 °C | | |
|---|---|---|
| Stunden | Belichtung (Sekunden) | vollvernetzte Keilstufen |
| 0 | 10 | 9 |
| 0,5 | 10 | 8 |
| 1 | 10 | 7 |
| 2 | 10 | 6 |
| 3 | 10 | 2* |
| 4 | 20 | - |
| - keine Vernetzung / *Platte nicht tonfrei | | |

### Beispiele 2 bis 8

Auf das Trägermaterial und die Photopolymerschicht aus Beispiel 1 wurden sauerstoffinhibierende Deckschichten aus folgenden Lösungen zu einem Trockenschichtgewicht von etwa 2 g/m² aufgebracht:
100 Gt einer 7%igen wäßrigen Lösung von Polyvinylalkohol (12 % Restacetylgruppen, K-Wert 4, d. h. Viskosität einer 4%igen wäßrigen Lösung bei 20 °C 4,0 mPa·s)
0,4 Gt Polymeres gemäß Tabelle II

**Tabelle II**

| Beispiel Nr. | Polymer | Viskosität nach Brookfield (mPa·s) | Molekulargewicht | Handelsname/Hersteller |
|---|---|---|---|---|
| 2 | PEI | 17000-28000 | | Polymin P (BASF) |
| 3 | " | 500- 1000 | | Polymin SK " |
| 4 | " | 450- 1500 | | Polymin SR " |
| 5 | " | 400- 900 | | Polymin RN " |
| 6 | " | | 60 000 | Corcat P600 (Virginia Chemicals) |
| 7 | " | | 1 800 | Corcat P18* " |
| 8 | " | | 1 200 | Corcat P12* " |
| PEI = Polyethylenimin | | | | |

| | | | | |
|---|---|---|---|---|
| * = Chemical Abstracts - Registriernummer CAS 9002-98-6 | | | | |

Die Druckplatten wurden wie in Beispiel 1 angegeben verarbeitet. Es wurden die in der folgenden Tabelle angegebenen vollvernetzten Keilstufen unter dem Kantenfilter 455 nm bei einer Belichtungszeit von 10 Sekunden und nach Lagerung im Umlufttrockenschrank bei 80 °C erhalten.

**Tabelle III**

| Lagertest bei 80 °C | | | | | | |
|---|---|---|---|---|---|---|
| Beispiel Nr. | Lagerzeit (Stunden) | | | | | |
| | 0 | 0,5 | 1 | 2 | 3 | 4 |
| 2 | 8 | 8 | 8 | 8 | 8 | 8 |
| 3 | 7 | 7 | 7 | 7 | 7 | 7 |
| 4 | 7 | 7 | 7 | 7 | 7 | 7 |
| 5 | 7 | 7 | 7 | 7 | 7 | 7 |
| 6 | 7 | 6 | 6 | 6 | 6 | 5 |
| 7 | 7 | 6 | 6 | 6 | 5 | 5 |
| 8 | 7 | 6 | 6 | 5 | 4 | 3 |

### Beispiel 9

Auf das Trägermaterial und die Photopolymerschicht aus Beispiel 1 wurde eine sauerstoffinhibierende Deckschicht aus folgender Lösung zu einem Trockenschichtgewicht von etwa 2 g/m² aufgebracht:
100 Gt einer 7%igen wäßrigen Lösung von Polyvinylalkohol (12 % Restacetylgruppen, K-Wert 8)
0,4 Gt Polyethylenimin (Polymin P)
Es wurde mit dieser Druckplatte ein Lagertest bei 100 °C durchgeführt. Nach 10 Sekunden Belichten unter dem Kantenfilter 455 nm und Entwickeln wie in Beispiel 1 aufgeführt, wurden die in der folgenden Tabelle angegebenen vollvernetzten Keilstufen erhalten:

**Tabelle IV**

| Lagertest bei 100 °C | |
|---|---|
| Stunden | Keilstufen |
| 0 | 7 |
| 1 | 7 |
| 2 | 7 |
| 3 | 6 |
| 4 | 5 |

### Beispiele 10 und 11

Auf den in Beispiel 1 angegebenen Schichtträger wurde unter gleichen Bedingungen wie dort eine Lösung folgender Zusammensetzung so aufgeschleudert, daß ein Schichtgewicht von 2 g/m² erhalten wurde:
4,0 Gt einer 34,8%igen Lösung eines Mischpolymerisats aus Methylmethacrylat und Methacrylsäure mit der Säurezahl 110 und dem mittleren Molekulargewicht 35 000 in 2-Butanon,
2,8 Gt des Umsetzungsprodukts von Trietholamin mit 3 mol Glycidylmethacrylat,
0,04 Gt Eosin (alkohollöslich) C.I. 45386,
0,03 Gt 2,4-Bis-trichlormethyl-6-(4-styryl-phenyl)-s-triazin und
0,049 Gt 9-Phenylacridin in
22,0 Gt Propylenglykolmonomethylether.

Auf diese Platte wurde einmal die Deckschicht aus Beispiel 9 mit einem Schichtgewicht von 2 g/m² aufgebracht (Beispiel 10) und zum Vergleich die Deckschicht aus Beispiel 1 in derselben Dicke (Beispiel 11). Mit beiden Platten wurde ein Langzeit-Lagertest bei 53 °C durchgeführt. Es wurden die in der Tabelle V abgeführten Ergebnisse gefunden. Die Druckplatten wurden 10 Sekunden unter dem Kantenfilter 455 nm belichtet und wie in Beispiel 1 beschrieben entwickelt.

**Tabelle V**

| Lagertest bei 53 °C | | |
|---|---|---|
| Lagerzeit Tage | vollvernetzte Keilstufen | |
| | Beispiel 10 | Beispiel 11 (V) |
| 1 | 6 | 5 |
| 2 | 6 | 4 |
| 3 | 6 | 2 * |
| 6 | 6 | - |
| 9 | 5 | - |
| 18 | 4 | - |
| - keine Vernetzung / *Platte nicht tonfrei | | |

Es ist ersichtlich, daß die Druckplatte mit Polyethylenimin in der Deckschicht eine deutlich bessere Lagerstabilität aufweist. Die inhibierende Wirkung der Deckschicht gegenüber Sauerstoff wird auch über längere Zeiträume stark verbessert.

### Beispiele 12 bis 14

Auf das Trägermaterial und die Photopolymerschicht aus Beispiel 1 wurden die in Tabelle VI aufgeführten sauerstoffinhibierenden Deckschichten aus folgender Lösung zu einem Trockenschichtgewicht von etwa 2 g/m² aufgebracht:
100 Gt Polyvinylalkohollösung wie in Beispiel 2,
x Gt Polyethylenimin (Polymin P) gemäß Tabelle VI.

**Tabelle VI**

| Beispiel Nr. | Gewichtsteile Polymin P |
|---|---|
| 12 | 0,8 |
| 13 | 1,2 |
| 14 | 1,6 |

Mit diesen Druckplatten wurde ein Lagertest bei 80 °C durchgeführt. Nach 10 Sekunden Belichten unter dem Kantenfilter 455 nm und Entwickeln wie in Beispiel 1 wurden die in Tabelle VII angegebenen vollvernetzten Keilstufen erhalten.

**Tabelle VII**

| Lagertest bei 80 °C | | | | | | |
|---|---|---|---|---|---|---|
| Beispiel Nr. | Lagerzeit (Stunden) | | | | | |
| | 0 | 0,5 | 1 | 2 | 3 | 4 |
| 12 | 8 | 8 | 8 | 8 | 8 | 8 |
| 13 | 8 | 8 | 8 | 8 | 8 | 8 |
| 14 | 8 | 8 | 8 | 8 | 8 | 8 |

## Patentansprüche

1. Photopolymerisierbares Aufzeichnungsmaterial mit einem Schichtträger, einer photopolymerisierbaren Schicht, die als wesentliche Bestandteile ein polymeres Bindemittel, eine radikalisch polymerisierbare Verbindung mit mindestens einer photooxydierbaren Gruppe und mindestens einer endständigen ethylenisch ungesättigten Gruppe sowie einen durch aktinisches Licht aktivierbaren Polymerisationsinitiator enthält, und einer Deckschicht, die ein für Luftsauerstoff wenig durchlässiges, wasserlösliches Polymeres enthält, dadurch gekennzeichnet, daß die Deckschicht ferner ein Luftsauerstoff bindendes, in Wasser bei 20 °C praktisch vollständig lösliches Polymeres enthält.

2. Aufzeichnungsmaterial nach Anspruch 1, dadurch gekennzeichnet, daß die Deckschicht eine Sauerstoffdurchlässigkeit von weniger als 30 cm³/m²/d/bar bei 20 °C hat.

3. Aufzeichnungsmaterial nach Anspruch 1, dadurch gekennzeichnet, daß das Luftsauerstoff bindende Polymere eine Verbindung mit aliphatischen Aminogruppen ist.

4. Aufzeichnungsmaterial nach Anspruch 1, dadurch gekennzeichnet, daß das Polymere mit aliphatischen Aminogruppen ein Polyalkylenimin ist.

5. Aufzeichnungsmaterial nach Anspruch 1, dadurch gekennzeichnet, daß die Deckschicht ein Flächengewicht von 0,5 bis 10 g/m² hat.

6. Aufzeichnungsmaterial nach Anspruch 1, dadurch gekennzeichnet, daß das Luftsauerstoff bindende Polymere ein Molekulargewicht von 300 bis 1 000 000 hat.

7. Aufzeichnungsmaterial nach Anspruch 1, dadurch gekennzeichnet, daß die Deckschicht 3 bis 60 Gew.-% Luftsauerstoff bindendes Polymeres und 40 bis 97 Gew.-% für Sauerstoff wenig durchlässiges Polymeres enthält.

8. Aufzeichnungsmaterial nach Anspruch 1, dadurch gekennzeichnet, daß die Schicht als Polymerisationsinitiator einen photoreduzierbaren Farbstoff enthält.

9. Aufzeichnungsmaterial nach Anspruch 1, dadurch gekennzeichnet, daß das Bindemittel wasserunlöslich und in wäßrig-alkalischen Lösungen löslich ist.

10. Aufzeichnungsmaterial nach Anspruch 1, dadurch gekennzeichnet, daß die photopolymerisierbare Schicht ein Flächengewicht von 0,5 bis 20 g/m² hat.

11. Aufzeichnungsmaterial nach Anspruch 1, dadurch gekennzeichnet, daß der Schichtträger eine hydrophile, für den Flachdruck geeignete Oberfläche hat.

## Claims

1. A photopolymerizable recording material comprising a base material, a photopolymerizable layer which contains as essential constituents a polymeric binder, a free-radically polymerizable compound having at least one photooxidizable group and at least one terminal ethylenically unsaturated group and also an actinically activable polymerization initiator, and a cover layer which contains a water-soluble polymer which is not very permeable to atmospheric oxygen, characterized in that the cover layer further contains a polymer which binds atmospheric oxygen and is virtually completely soluble in water at 20°C.

2. The recording material as claimed in claim 1, characterized in that the cover layer has an oxygen permeability of less than 30 cm³/m²/d/bar at 20°C.

3. The recording material as claimed in claim 1, characterized in that the polymer which binds atmospheric oxygen is a compound having aliphatic amino groups.

4. The recording material as claimed in claim 1, characterized in that the polymer having aliphatic amino groups is a polyalkyleneimine.

5. The recording material as claimed in claim 1, characterized in that the cover has a basis weight of 0.5 to 10 g/m².

6. The recording material as claimed in claim 1, characterized in that the polymer which binds atmospheric oxygen has a molecular weight of 300 to 1,000,000.

7. The recording material as claimed in claim 1, characterized in that the cover layer contains 3 to 60% by weight of polymer which binds atmospheric oxygen and 40 to 97% by weight of polymer which is not very permeable to oxygen.

8. The recording material as claimed in claim 1, characterized in that the layer contains a photo-reducible dye as the polymerization initiator.

9. The recording material as claimed in claim 1, characterized in that the binder is water-insoluble and soluble in aqueous alkaline solutions.

10. The recording material as claimed in claim 1, characterized in that the photopolymerizable layer has a basis weight of 0.5 to 20 g/m².

11. The recording material as claimed in claim 1, characterized in that the base material has a hydrophilic surface suitable for planographic printing.

## Revendications

1. Matériau de reprographie photopolymérisable comportant un support de couche, une couche photopolymérisable qui contient, en tant que composants essentiels, un liant polymère, un composé polymérisable par polymérisation radicalaire, comportant au moins un groupe photo-oxydable et au moins un groupe à insaturation éthylénique en bout de chaîne, ainsi qu'un initiateur de polymérisation activable par de la lumière actinique, et une couche de recouvrement qui contient un polymère soluble dans l'eau et peu perméable à l'oxygène de l'air, caractérisé en ce que la couche de recouvrement contient en outre un polymère fixant l'oxygène de l'air et pratiquement totalement soluble dans de l'eau à 20°C.

2. Matériau de reprographie selon la revendication 1, caractérisé en ce que la couche de recouvrement a une perméabilité à l'oxygène de moins de 30 cm³/m²/j/bar à 20°C.

3. Matériau de reprographie selon la revendication 1, caractérisé en ce que le polymère fixant l'oxygène de l'air est un composé à groupes amino aliphatiques.

4. Matériau de reprographie selon la revendication 1, caractérisé en ce que le polymère à groupes amino aliphatiques est une polyalkylène-imine.

5. Matériau de reprographie selon la revendication 1, caractérisé en ce que la couche de recouvrement a un poids par unité de surface de 0,5 à 10 g/m².

6. Matériau de reprographie selon la revendication 1, caractérisé en ce que le polymère fixant l'oxygène de l'air a une masse moléculaire de 300 à 1 000 000.

7. Matériau de reprographie selon la revendication 1, caractérisé en ce que la couche de recouvrement contient de 3 à 60 % en poids de polymère fixant l'oxygène de l'air et de 40 à 97 % en poids de polymère peu perméable à l'oxygène.

8. Matériau de reprographie selon la revendication 1, caractérisé en ce que la couche contient, en tant qu'initiateur de polymérisation, un colorant photoréductible.

9. Matériau de reprographie selon la revendication 1, caractérisé en ce que le liant est insoluble dans l'eau et soluble dans des solutions aqueuses-alcalines.

10. Matériau de reprographie selon la revendication 1, caractérisé en ce que la couche photopolymérisable a un poids par unité de surface de 0,5 à 20 g/m².

11. Matériau de reprographie selon la revendication 1, caractérisé en ce que le support de couche a une surface hydrophile, appropriée à l'impression à plat.
